# EUROPÄISCHE PATENTSCHRIFT

(11) **EP 0 989 612 B1**
(45) Veröffentlichungstag und Bekanntmachung des Hinweises auf die Patenterteilung: **20.02.2002**
(21) Anmeldenummer: 99118397.1
(22) Anmeldetag: 16.09.1999
(51) Int. Cl.: H01L 27/108, H01L 21/8242, H01L 27/115

(54) **Speicherzellenanordnung und entsprechendes Herstellungsverfahren**
Memory cell array and corresponding fabrication process
Réseau de cellules de mémoire et procédé de fabrication

(30) Priorität: 24.09.1998 DE 19843979
(43) Veröffentlichungstag der Anmeldung: 29.03.2000
(73) Patentinhaber: Infineon Technologies AG, 81669 München (DE)
(72) Erfinder: Schlösser, Till, Dr., 81825 München (DE); Hofmann, Franz, Dr., 80995 München (DE); Krautschneider, Wolfgang, Prof., 21149 Hamburg (DE)
(74) Vertreter: Reinhard - Skuhra - Weise & Partner

(56) Entgegenhaltungen:
- DE-A- 19 510 042
- US-A- 5 736 761
- PATENT ABSTRACTS OF JAPAN vol. 1996, no. 05, 31. Mai 1996 (1996-05-31) & JP 08 017942 A (NEC CORP), 19. Januar 1996 (1996-01-19)

## Beschreibung

Die vorliegende Erfindung betrifft eine Speicherzellenanordnung mit einer Vielzahl von in einem Halbleitersubstrat vorgesehenen ferroelektrischen Speicherzellen (ferroelektrischer Speicher (FeRAM)) bzw. einen nichtflüchtigen Speicher mit wahlfreiem Zugriff (NVRAM oder DRAM) mit dielektrischen Speicherzellen und ein entsprechendes Herstellungsverfahren. Halbleitersubstrat soll dabei im allgemeinen Sinne verstanden werden, also als Wafersubstrat, Epitaxiesubstrat, Wannensubstrat usw.

Obwohl auf Speicher aus einem beliebigen Grundmaterial anwendbar, werden die vorliegende Erfindung sowie die ihr zugrundeliegende Problematik in bezug auf einen Speicher auf Siliziumbasis erläutert.

Allgemein besteht ein DRAM-Speicher aus einer Speicherzellenanordnung, deren einzelne Speicherzellen einen Auswahltransistor und einen damit verbundenen Kondensator aufweisen. Ein ROM-Speicher hat als Speicherzelle einfach nur einen Transistor.

Zunächst basierten die Speicherzellenanordnungen auf überwiegend planaren Konzepten. Unter der Vorgabe einer ständig größer werdenden Packungsdichte ist es nunmehr bereits für MaskROM-Anwendungen (Festwertspeicher) vorgeschlagen worden, die Zellfläche des Speichers durch das Einbringen paralleler Längsgräben zu falten und somit die Projektion der Zellfläche auf die Waferoberfläche um bis zu 50% zu reduzieren. Bei DRAMs ist insbesondere die Ausnutzung der vertikalen Richtung in Form von Kapazitäten als Trench- oder Stacked-Kondensator bekannt.

Das allgemeine Ziel der Speichertechnologie ist es, 1-Transistor-Zellen herzustellen, die die deutlich kleiner als 8 F² sind, wobei F die minimale Strukturgröße der betreffenden Technologie ist.

Die meisten bisherigen Speicherkonzepte mit einer Grundfläche kleiner als 6 F² beinhalten vertikale Transistoren.

Aus der DE 195 14 834 ist eine Festwertspeicherzellanordnung bekannt, die Speicherzellen mit einem vertikalen MOS-Transistor aufweist. Die Speicherzellen sind entlang gegenüberliegenden Flanken von streifenförmigen, parallel verlaufenden Isolationsgräben angeordnet. Werden Breite und Abstand der Isolationsgräben gleich groß gewählt, so ist der minimale Platzbedarf pro Speicherzelle theoretisch 2F², wobei F die minimale Strukturgröße der Technologie ist.

Die DE 195 10 042 offenbart eine Festwertspeicherzellanordnung, bei der die Speicherzellen in parallel verlaufenden Zeilen angeordnet sind, wobei Längsgräben vorgesehen sind, die parallel zu den Zeilen verlaufen. Die Zeilen sind dabei jeweils abwechselnd auf der Hauptfläche zwischen benachbarten Längsgräben und auf dem Boden der Längsgräben angeordnet. Vertikale Isolationsstrukturen sind zu gegenseitigen Isolation der Speicherzellen, die jeweils einen MOS-Transistor umfassen, vorgesehen. Quer zu den Zeilen verlaufen Wortleitungen, die jeweils mit den Gateelektroden von entlang unterschiedlichen Zeilen angeordneten MOS-Transistoren verbunden sind.

Hierbei ist der minimale Platzbedarf pro Speicherzelle theoretisch 2 F², wobei F die minimale Strukturgröße der Technologie ist. Dies ermöglicht es, fast die gesamte Silizium-Oberfläche als aktive Fläche zu nutzen. So kann man also sehr kleine Zellflächen realisieren, ohne auf vertikale Transistoren zurückgreifen zu müssen. Das führt zu einer Erniedrigung der Prozeßkosten und zu einer Erhöhung der Zuverlässigkeit. Insbesondere bei ferroelektrischen Speicherzellen, bei denen die Leckstrom-anforderungen nicht ganz so hoch sind wie beim DRAM, steckt hinter solchen planaren Konzepten ein großes Potential.

Aus der DE 195 43 539 ist eine RAM-Speicherzellenanordnung mit einem vertikalen Speicherkondensator mit einem ferroelektrischen oder paraelektrischen Speicherdielektrikum bekannt. Zur Herstellung des Speicherkondensators wird großflächig eine dielektrische Schicht für das Speicherdielektrikum erzeugt. Anschließend wird die dielektrische Schicht strukturiert, und es werden erste und zweite Elektroden für die Speicherkondensatoren gebildet.

Gemäß der DE 195 43 539 wird als Speicherdielektrikum ferroelektrisches Material für nichtflüchtige Speicher verwendet, da dieses eine spontane Polarisation aufweist, die auch ohne externes elektrisches Feld vorhanden ist. Para-elektrisches Material hingegen wird bei DRAM-Anwendungen verwendet, bei denen ein Auffrischungszyklus vorgesehen ist.

In der Praxis lassen sich mit den bekannten Konzepten für Speicherzellen bestehend aus einem Auswahltransistor und einer Speicherkapazität (z.B. DRAM) momentan allerdings nur Zellgrößen für eine Speicherzelle von ca. 9 F² erzielen. Das Ziel ist eine Zellgröße von 8 F² ab der 1 Gb-Generation mit F = 0,18 µm.

Die der vorliegenden Erfindung zugrundeliegende Aufgabe besteht allgemein darin, eine einfach und zuverlässig herstellbare dicht gepackte Speicherzellenanordnung mit vorzugsweise ferroelektrischen Speicherzellen sowie ein entsprechendes Herstellungsverfahren anzugeben.

Erfindungsgemäß wird diese Aufgabe durch die in Anspruch 1 angegebene Speicherzellenanordnung mit vorzugsweise ferroelektrischen Speicherzellen sowie das in Anspruch 11 angegebene Herstellungsverfahren gelöst.

Die erfindungsgemäße Speicherzellenanordnung mit vorzugsweise ferroelektrischen Speicherzellen weist gegenüber den bekannten Speicherzellenanordnungen den Vorteil auf, daß sie eine erreichbare minimale Zellgröße von kleiner 6 F² mit planaren Transistoren aufweist, welche sowohl auf Grabenböden als auch auf Stegkronen angeordnet sind. Die Speicherzellenanordnung ist einfach herstellbar und bedarf keiner STI-Isolationsgräben wie bisherige Konzepte.

Im Gegensatz zum üblichen Verfahren zur Herstellung eines DRAM mit Stacked-Kondensator läuft die Bitleitung bei der erfindungsgemäßen Speicherzellenanordnung nicht mehr senkrecht zur Wortleitung, sondern unter einem Winkel von typischerweise 60° dazu. Zum Anschließen der Bitleitungen für die Transistoren werden diese mit entsprechenden kurzen (von Stegkronen) bzw. langen (von Grabenböden) Kontaktstöpseln auf die ursprüngliche Halbleitersubstrathöhe hochgeführt. Die Kontaktstöpsel sind self-aligned bzw. selbstausgerichtet ausführbar. Ansonsten kann ebenfalls ausschließlich auf übliche Prozeßschritte zurückgegriffen werden.

Die der vorliegenden Erfindung zugrundeliegende Idee besteht darin, daß die Auswahltransistoren als Planartransistoren sowohl auf den Grabenböden als auch auf den Stegkronen zueinander versetzt realisiert werden, wobei über eine Bitleitung beide Typen von Auswahltransistoren erreichbar sind und jeweils alternierend der eine und andere Typ über die Wortleitungen. Die minimale planare Grundfläche der Speicherzelle mit dielektrischem oder ferroelektrischem Kondensator beträgt etwa 4 F². Die Größe von ca. 5 F² im Fall, daß die Gräben eine Breite von 1,5 F zum Ausgleich des Isolationsspacers und die Stege eine geringere Breite von F aufweisen, ist bei dem angegebenen Herstellungsverfahren ohne weiteres realisierbar.

In den jeweiligen Unteransprüchen finden sich vorteilhafte Weiterbildungen und Verbesserungen der in Anspruch 1 angegebenen Speicherzellenanordnung mit vorzugsweise ferroelektrischen Speicherzellen bzw. des in Anspruch 11 angegebenen Herstellungsverfahrens.

Gemäß einer bevorzugten Weiterbildung sind entlang der Grabenwände isolierende Abstandshalter, vorzugsweise aus Nitrid oder Oxid, vorgesehen. Dies sorgt für eine gute gegenseitige Isolation der ersten und zweiten Auswahltransistoren.

Gemäß einer weiteren bevorzugten Weiterbildung sind die Gräben um die Dicke der Abstandshalter breiter als die Stege. Dies gleicht den Flächenverlust durch die Abstandshalter aus.

Gemäß einer weiteren bevorzugten Weiterbildung sind entlang der Wortleitungen und/oder Bitleitungen isolierende Abstandshalter, vorzugsweise aus Nitrid oder Oxid, vorgesehen.

Gemäß einer weiteren bevorzugten Weiterbildung sind die Gräben mit einer Isolatorschicht gefüllt, durch die jeweilige erste Kontaktstöpsel zur Verbindung der ersten Auswahltransistoren mit den Bitleitungen laufen.

Gemäß einer weiteren bevorzugten Weiterbildung sind die Stege mit einer Isolatorschicht überdeckt, durch die jeweilige zweite Kontaktstöpsel zur Verbindung der zweiten Auswahltransistoren mit den Wortleitungen bzw. Bitleitungen laufen.

Gemäß einer weiteren bevorzugten Weiterbildung ist auf den Wortleitungen und Bitleitungen eine weitere Isolatorschicht vorgesehen und sind jeweilige Stapelkondensatoren vorgesehen, welche über den jeweiligen Kondensatorkontakt mit dem Drain-Gebiet des betreffenden Auswahltransistors verbunden sind.

Gemäß einer weiteren bevorzugten Weiterbildung ist eine Schicht mit einem Dielektrikum mit möglichst hoher Dielektrizitätskonstante, vorzugsweise aus einem Ferroelektrikum, z.B. aus Strontium-Wismut-Tantalat, in den Stapelkondensatoren vorgesehen.

Gemäß einer weiteren bevorzugten Weiterbildung ist über der Schicht aus einem Ferroelektrikum großflächig eine gemeinsame obere Kondensatorelektrode vorgesehen.

Gemäß einer weiteren bevorzugten Weiterbildung weisen die Gräben, die Stege, die Wortleitungen und die Bitleitungen jeweils eine minimale Strukturbreite F auf, und nimmt jede Speicherzelle einen Bereich von 4 F² ein.

Ausführungsbeispiele der Erfindung sind in den Zeichnungen dargestellt und in der nachfolgenden Beschreibung näher erläutert.

Es zeigen:
- Fig. 1: eine Querschnittsansicht eines Zellenfeldes gemäß einer Ausführungsform der erfindungsgemäßen Speicherzellenanordnung in einem ersten Prozeßstadium;
- Fig. 2: eine Aufsicht auf ein Zellenfeld gemäß der Ausführungsform der erfindungsgemäßen Speicherzellenanordnung in dem ersten Prozeßstadium gemäß Fig. 1;
- Fig. 3: eine Querschnittsansicht eines Zellenfeldes gemäß der Ausführungsform der erfindungsgemäßen Speicherzellenanordnung in einem zweiten Prozeßstadium;
- Fig. 4: eine Aufsicht auf ein Zellenfeld gemäß der Ausführungsform der erfindungsgemäßen Speicherzellenanordnung in dem zweiten Prozeßstadium gemäß Fig. 3;
- Fig. 5: eine Aufsicht auf ein Zellenfeld gemäß der Ausführungsform der erfindungsgemäßen Speicherzellenanordnung in einem dritten Prozeßstadium; und
- Fig. 6: eine Aufsicht auf ein Zellenfeld gemäß der Ausführungsform der erfindungsgemäßen Speicherzellenanordnung in einem vierten Prozeßstadium.

In den Figuren bezeichnen gleiche Bezugszeichen gleiche oder funktionsgleiche Bestandteile.

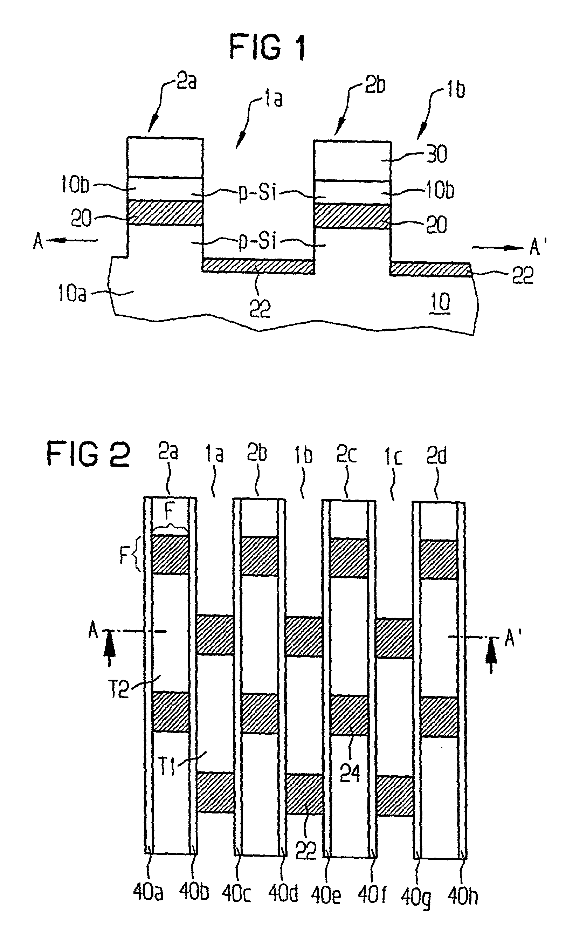

Fig. 1 ist eine Querschnittsansicht eines Zellenfeldes gemäß einer Ausführungsform der erfindungsgemäßen Speicherzellenanordnung in einem ersten Prozeßstadium und Fig. 2 eine entsprechende Aufsicht.

Wie in Fig. 1 und 2 gezeigt, wird zunächst ein Halbleitersubstrat 10 mit z.B. einer p-Wanne bzw. einer p-Epitaxieschicht bereitgestellt.

Zunächst wird eine ganzflächige Implantation zum Bilden einer Kanalstoppschicht 20 mit dem Maximum ungefähr in der späteren halben Grabentiefe durchgeführt.

Anschließend wird in einem Fotoprozeß eine Nitrid-Hartmaske 30 strukturiert und damit eine perodische Anordnung von in Längsrichtung in der Hauptfläche des Halbleitersubstrats 10 parallel verlaufenden alternierenden Gräben 1a-c und Stegen 2a-d geätzt.

Die Kanalstoppschicht 20 teilt das Halbleitersubstrat 10 in einen unteren Bereich 10a einschließlich der Grabenböden und einen oberen Bereich 10b einschließlich der Stegkronen, worin später jeweilige erste bzw. zweite Auswahltransistoren gebildet werden.

Nach einem weiteren Fotoschritt mit Lackstreifen, die senkrecht zu den Gräben 1a-c verlaufen, werden flache Graben-Kanalstoppbereiche 22 zur Isolation späterer benachbarter Transistoren in den Gräben implantiert.

Anschließend wird TEOS-Oxid abgeschieden und durch chemischmechanisches Polieren unter Verwendung der Hartmaske 30 aus Nitrid als Stopp zurückgeschliffen. Nach einer darauffolgenden nassen Nitridätzung und einem entsprechenden weiteren Fotoschritt für die Stege können flache Steg-Kanalstoppbereiche 24 zur Isolation späterer benachbarter Transistoren in den Stegen implantiert werden. Danach werden das TEOS-Oxid herausgeätzt und Nitrid-Spacer bzw. Abstandshalter 40a-h (nicht in Fig.1 gezeigt) entlang der Grabenwände gebildet, was zum in Fig. 2 gezeigten Prozeßstadium führt.

Wie in Fig. 2 durch T1 und T2 angedeutet, liegen in den Gräben die Bereiche für spätere erste Transistoren T1, die durch die Graben-Kanalstoppbereiche 22 getrennt sind, bzw. liegen auf den Stegen die Bereiche für spätere zweite Transistoren T2, die durch die Steg-Kanalstoppbereiche 24 getrennt sind.

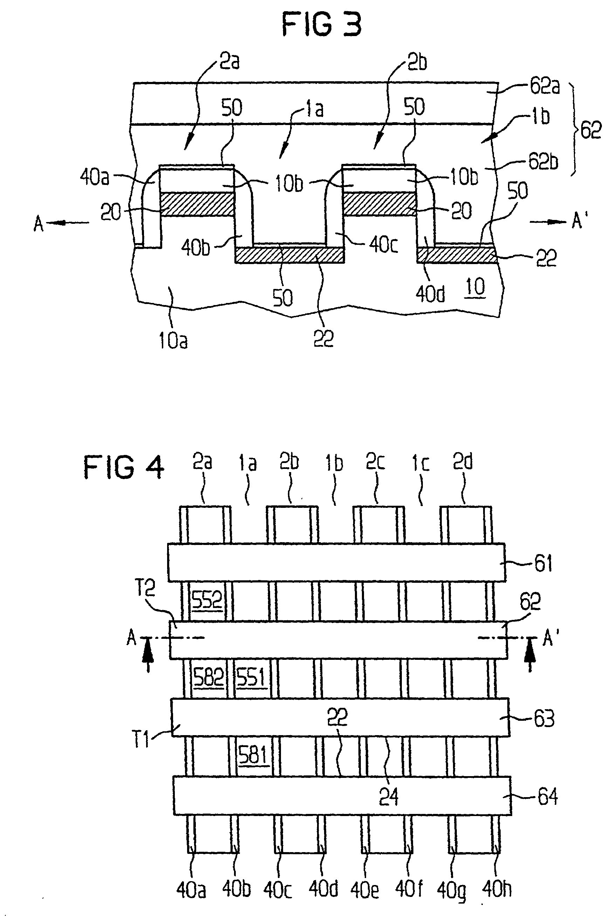

Fig. 3 ist eine Querschnittsansicht eines Zellenfeldes gemäß der Ausführungsform der erfindungsgemäßen Speicherzellenanordnung in einem zweiten Prozeßstadium und Fig. 4 eine entsprechende Aufsicht.

Wie in Fig. 3 und 4 gezeigt, erfolgen als nächste Prozeßschritte eine Implantation in die Kanalbereiche zur Einstellung der Schwellspannung und darauffolgend ein Aufwachsen eines Gateoxides 50. Für den Gateanschluß durch die Wortleitungen 61-64 werden gemäß üblicher Prozeßtechnologie Polysilizium 62b, Silizid 62a und Nitrid abgeschieden und strukturiert, sowie eine Nitridschicht zur Bildung eines (nicht gezeigten) Nitridspacers abgeschieden und strukturiert.

Danach werden selbstjustierende Source/Drain-Implantationen zur gleichzeitigen Bildung der Source- und Drainbereiche (z.B. 551, 552 bzw. 581, 582) der ersten und zweiten Auswahltransistoren durchgeführt. Wie anhand der Transistoren T1 und T2 angedeutet, sind die Transistoren derart in Längsrichtung zueinander versetzt, daß in Querrichtung in der Hauptfläche des Halbleitersubstrats 10 die Source- und Drainbereiche, beispielsweise 582, 551, alternieren. Im Bereich, der von den Wortleitungen 61-64 überdeckt ist, alternieren dementsprechend die Gate-/Kanalbereiche und die Graben- bzw. Steg-Kanalstoppbereiche 22 bzw. 24.

Wenn die Gräben 1a-c, die Stege 2a-d, die Wortleitungen 61-64 und die Bitleitungen 91-94 jeweils die prozeßbedingte minimale Strukturbreite F aufweisen, nimmt jeder Transistor einen Bereich von 3 F² ein, zudem ein Kanalstoppbereich von ½ F² auf jeder Seite hinzukommt, weshalb eine Speicherzelle einen Bereich von 4 F² zur Verfügung hat.

Nun kann ein Zwischenoxid als Isolationsschicht in den Gräben 1a-c und auf den Stegen 2a-d abgeschieden bzw. aufgewachsen und planarisiert werden.

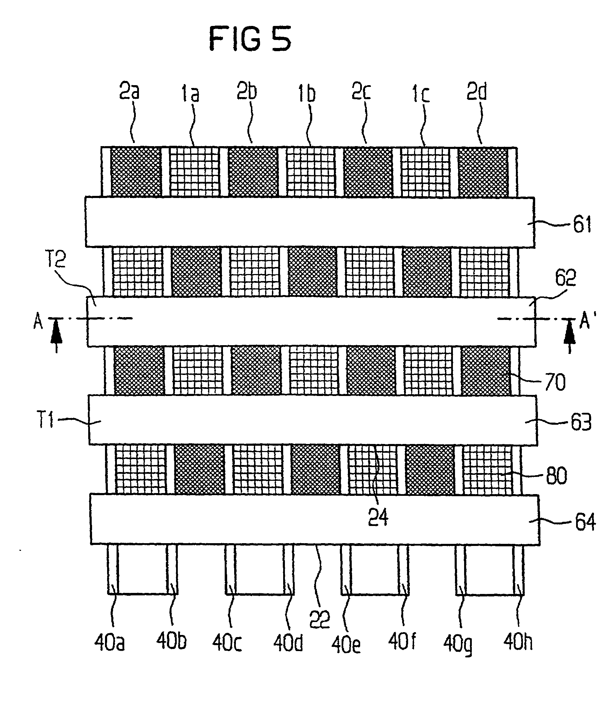

Fig. 5 ist eine Aufsicht auf ein Zellenfeld gemäß der Ausführungsform der erfindungsgemäßen Speicherzellenanordnung in einem dritten Prozeßstadium.

Wie in Fig. 5 gezeigt, werden in das Zwischenoxid nach einem weiteren Fotoschritt Bitleitungskontaktlöcher 80 geätzt, um einen jeweiligen Bitleitungsanschluß an die Sourcebereiche der Auswahltransistoren zu schaffen.

Dabei sind tiefe Kontaktlöcher in den Gräben und flache Kontaktlöcher auf den Stegen zu schaffen. Dies kann bei einem ausreichend selektiven Ätzprozeß gemeinsam erfolgen, ansonsten müßten zwei Fotoschritte durchgeführt werden. Zweckmäßigerweise werden die Kontaktiöcher mit einem dünnen Nitrid-spacer ausgekleidet.

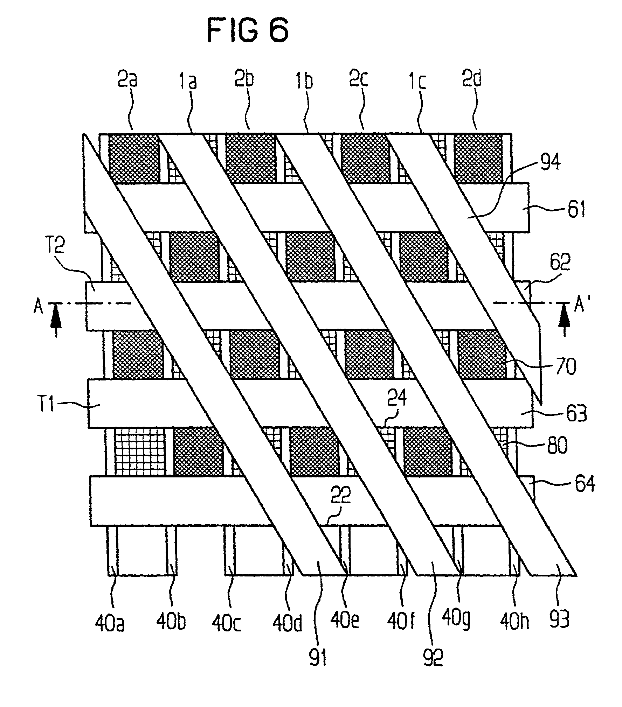

Fig. 6 ist eine Aufsicht auf ein Zellenfeld gemäß der Ausführungsform der erfindungsgemäßen Speicherzellenanordnung in einem vierten Prozeßstadium.

Analog wie die Wortleitungen 61-64 werden die Bitleitungen 91-94 gemäß üblicher Prozeßtechnologie gebildet, wird also Polysilizium 62b, Silizid 62a oder Wolfram und Nitrid abgeschieden und strukturiert, sowie eine Nitridschicht zur Bildung eines (nicht gezeigten) Nitridspacers abgeschieden und strukturiert.

Insbesondere verlaufen die isolierten Bitleitungen 91-94 in Schrägrichtung entlang der Hauptfläche des Halbleitersubstrats 10 zur Anschluß der ersten und zweiten Auswahltransistoren T1, T2 in den jeweiligen Sourcebereichen. Nun erfolgt eine weitere Zwischenoxidabscheidung und Planarisierung.

Wie in Fig. 6 mit Bezugszeichen 70 angedeutet, werden in dieses weitere Zwischenoxid nach einem weiteren Fotoschritt Kondensatorkontaktlöcher selbstjustiert geätzt, um einen jeweiligen Kondensatoranschluß an die Drainbereiche der Auswahltransistoren zu schaffen. Dabei sind ebenfalls tiefe Kontaktlöcher in den Gräben und flache Kontaktlöcher auf den Stegen zu schaffen, und zwar analog zur den oben beschriebenen Bitleitungskontakten.

Abschließend wird auf den Wortleitungen 61-64 und Bitleitungen 91-94 eine weitere Isolatorschicht vorgesehen, auf der jeweilige Stapelkondensatoren vorgesehen werden, welche über den jeweiligen Kondensatorkontakt 70 mit dem Drain-Gebiet des betreffenden Auswahltransistors T1, T2 verbunden werden. Im bevorzugten Fall wird eine Schicht aus einem Ferroelektrikum, z.B. aus Strontium-Wismut-Tantalat, in den Stapelkondensatoren vorgesehen.

Die angegebenen Grundmaterialien und Zusatzmaterialien sind nur beispielhaft und können durch geeignete andere Materialien ersetzt werden.

Folgende sonstige ferroelektische Materialien sind u.a. verwendbar: Blei-Zirkon-Titanat, Bariumtitanat, Blei-Lanthan-Titanat, Strontium-Wismut-Tantalat, Wismuttitanat.

Auch ist das Kondensator-Dielektrikum nicht auf Ferroelektrika beschränkt, sondern durch andere geeignete Dielektrika, z.B. die paraelektrischen Materialien Barium-Strontium-Titanat, Strontiumtitanat Barium-Zirkon-Titanat, ersetzbar.

Es kann auch eine sehr dünne (elektrische Äquivalentdicke ca. 3 nm) Oxid-Nitrid-Schicht (ON) oder Tantalpentoxidschicht (Ta₂O₅) oder Titandioxidschicht (TiO₂) verwendet werden, die auf einer zur Vergrößerung der Oberfläche aufgerauhten Polysiliziumelektrode (rugged plug oder hemispherical grain poly HSG) aufgebracht wird.

## Patentansprüche

1. Speicherzellenanordnung mit einer Vielzahl von in einem Halbleitersubstrat (10) vorgesehenen ferroelektrischen oder dynamischen Speicherzellen (S) mit:
in Längsrichtung in der Hauptfläche des Halbleitersubstrats (10) parallel verlaufenden alternierenden Gräben (1a-1e) und Stegen (2a-d) ;
wobei
in den Stegen (2a-d) eine Kanalstoppschicht (20) vergraben ist, die das Halbleitersubstrat (10) in einen unteren Bereich (10a) einschließlich der Grabenböden und einen oberen Bereich (10b) einschließlich der Stegkronen teilt;
entlang der Grabenböden im unteren Bereich (10a) des Halbleitersubstrats (10) erste planare Auswahltransistoren (T1) mit dazwischenliegenden Graben-Kanalstoppbereichen (22) angeordnet sind;
entlang der Stegkronen im oberen Bereich (10b) des Halbleitersubstrats (10) zweite planare Auswahltransistoren (T2) mit dazwischenliegenden Steg-Kanalstoppbereichen (24) angeordnet sind;
die ersten und zweiten Auswahltransistoren (T1, T2) jeweilige Source-, Gate-, Kanal- und Drainbereiche aufweisen, die derart in Längsrichtung zueinander versetzt sind, daß in Querrichtung in der Hauptfläche des Halbleitersubstrats (10) Source- und Drainbereiche (582, 551) der ersten und zweiten Auswahltransistoren (T1, T2) alternieren;
in Querrichtung entlang der Hauptfläche des Halbleitersubstrats (10) verlaufenden isolierten Wortleitungen (61-64) zur Ansteuerung der ersten und zweiten Auswahltransistoren (T1, T2) in den jeweiligen Gatebereichen;
in Schrägrichtung entlang der Hauptfläche des Halbleitersubstrats (10) verlaufenden isolierten Bitleitungen (91-94) zur Anschließen der ersten und zweiten Auswahltransistoren (T1, T2) in den jeweiligen Sourcebereichen (80); und
jeweils einem über einen Kondensatorkontakt (70) mit dem Drain-Gebiet des betreffenden Auswahltransistors (T1, T2) verbundenen vorzugsweise ferroelektrischen Kondensator.

2. Speicherzellenanordnung nach Anspruch 1, **dadurch gekennzeichnet, daß** entlang der Grabenwände isolierende Abstandshalter (40a-h), vorzugsweise aus Nitrid oder Oxid, vorgesehen sind.

3. Speicherzellenanordnung nach Anspruch 2, **dadurch gekennzeichnet, daß** die Gräben (1a-c) um die Dicke der Abstandshalter (40a-h) breiter sind als die Stege (2a-d).

4. Speicherzellenanordnung nach einem der vorhergehenden Ansprüche, **dadurch gekennzeichnet, daß** entlang der Wortleitungen (61-64) und/oder Bitleitungen (91-94) isolierende Abstandshalter, vorzugsweise aus Nitrid oder Oxid, vorgesehen sind.

5. Speicherzellenanordnung nach einem der vorhergehenden Ansprüche, **dadurch gekennzeichnet, daß** die Gräben (1a-c) mit einer Isolatorschicht gefüllt sind, durch die jeweilige erste Kontaktstöpsel zur Verbindung der ersten Auswahltransistoren (T1) mit den Bitleitungen (91-94) laufen.

6. Speicherzellenanordnung nach einem der vorhergehenden Ansprüche, **dadurch gekennzeichnet, daß** die Stege (2a-d) mit einer Isolatorschicht überdeckt sind, durch die jeweilige zweite Kontaktstöpsel zur Verbindung der zweiten Auswahltransistoren (T2) mit den Bitleitungen (91-94) laufen.

7. Speicherzellenanordnung nach einem der vorhergehenden Ansprüche, **dadurch gekennzeichnet, daß** auf den Wortleitungen (61-64) und Bitleitungen (91-94) eine weitere Isolatorschicht vorgesehen ist, jeweilige Stapelkondensatoren vorgesehen sind, welche über den jeweiligen Kondensatorkontakt (70) mit dem Drain-Gebiet des betreffenden Auswahltransistors (T1, T2) verbunden sind.

8. Speicherzellenanordnung nach Anspruch 7, **dadurch gekennzeichnet, daß** eine Schicht aus einem Ferroelektrikum, vorzugsweise aus Strontium-Wismut-Tantalat, oder einem Dielektrikum, vorzugsweise Oxid, Siliziumnitrid, Tantalpentoxidschicht (Ta₂O₅) oder Titandioxidschicht (TiO₂) oder Barium-Strontium-Titanat, in den Stapelkondensatoren vorgesehen ist.

9. Speicherzellenanordnung nach Anspruch 7 oder 8, **dadurch gekennzeichnet, daß** über der Schicht aus einem Ferroelektrikum großflächig eine gemeinsame obere Kondensator- elektrode vorgesehen ist.

10. Speicherzellenanordnung nach einem der vorhergehenden Ansprüche, **dadurch gekennzeichnet, daß** die Gräben (1a-c), die Stege (2a-d), die Wortleitungen (61-64) und die Bitleitungen (91-94) jeweils eine minimale Strukturbreite F aufweisen, und jede Speicherzelle einen Bereich von 4 F² einnimmt.

11. Verfahren zur Herstellung einer Speicherzellenanordnung mit vorzugsweise ferroelektrischen Speicherzellen nach mindestens einem der vorhergehenden Ansprüche mit den Schritten:
Bereitstellen des Halbleitersubstrats (10);
Vorsehen einer Kanalstoppschicht (20), die das Halbleitersubstrat (10) in einen unteren Bereich (10a) einschließlich der Grabenböden und einen oberen Bereich (10b) einschließlich der Stegkronen teilt;
Vorsehen einer perodischen Anordnung von in Längsrichtung in der Hauptfläche des Halbleitersubstrats (10) parallel verlaufenden alternierenden Gräben (1a-c) und Stegen (2a-d);
Bilden von Graben-Kanalstoppbereichen (22) in den Gräben (la-c) und Steg-Kanalstoppbereichen (24) auf den Stegen (2a-d), welche erste und zweite Auswahltransistoren (T1, T2) definieren, die jeweilige Source-, Gate-, Kanal- und Drainbereiche aufweisen, die derart in Längsrichtung zueinander versetzt sind, daß in Querrichtung in der Hauptfläche des Halbleitersubstrats (10) Source- und Drainbereiche (582, 551) der ersten und zweiten Auswahltransistoren (T1, T2) alternieren;
Ausbilden der Source-, Gate-, Kanal- und Drainbereiche der ersten und zweiten Auswahltransistoren (T1, T2);
Bilden von in Querrichtung entlang der Hauptfläche des Halbleitersubstrats (10) verlaufenden isolierten Wortleitungen (61-64) zur Ansteuerung der ersten und zweiten Auswahltransistoren (T1, T2) in den jeweiligen Gatebereichen;
Bilden von in Schrägrichtung entlang der Hauptfläche des Halbleitersubstrats (10) verlaufenden isolierten Bitleitungen (91-94) zur Anschließen der ersten und zweiten Auswahltransistoren (T1, T2) in den jeweiligen Sourcebereichen (80); und
Bilden von jeweils einem über einen Kondensatorkontakt (70) mit dem Drain-Gebiet des betreffenden Auswahltransistors (T1, T2) verbundenen vorzugsweise ferroelektrischen Kondensator.

12. Verfahren nach Anspruch 11, **gekennzeichnet durch** die Schritte:
Durchführen selbstjustierender Source/Drain-Implantationen zur gleichzeitigen Bildung der Source- und Drainbereiche (z.B. 551, 552 bzw. 581, 582) der ersten und zweiten Auswahltransistoren.

13. Verfahren nach Anspruch 11 oder 12, **dadurch gekennzeichnet, daß** das Bilden von den Steg-Kanalstoppbereichen (24) auf den Stegen (2a-d) durch folgende Schritte geschieht:
Abscheiden und Planarisieren von TEOS-Oxid zum Füllen der Gräben (1a-c);
selektives Bilden der Steg-Kanalstoppbereiche (24) in den Stegen; und
Entfernen des TEOS-Oxids.

14. Verfahren nach einem der Ansprüche 11 bis 13, **dadurch gekennzeichnet, daß** isolierende Abstandshalter (40a-h) entlang der Grabenwände gebildet werden.

## Claims

1. Memory cell arrangement having a multiplicity of ferroelectric or dynamic memory cells (S) provided in a semiconductor substrate (10), having:
alternate trenches (1a-1e) and ridges (2a-d) running parallel in the longitudinal direction in the main area of the semiconductor substrate (10);
wherein
a channel stop layer (20) is buried in the ridges (2a-d), which layer divides the semiconductor substrate (10) into a lower region (10a) including the trench bottoms and an upper region (10b) including the ridge crowns;
first planar selection transistors (T1) with intervening trench channel stop regions (22) are arranged along the trench bottoms in the lower region (10a) of the semiconductor substrate (10);
second planar selection transistors (T2) with intervening ridge channel stop regions (24) are arranged along the ridge crowns in the upper region (10b) of the semiconductor substrate (10);
the first and second selection transistors (T1, T2) have respective source, gate, channel and drain regions which are offset with respect to one another in the longitudinal direction in such a way that source and drain regions (582, 551) of the first and second selection transistors (T1, T2) alternate in the transverse direction in the main area of the semiconductor substrate (10);
insulated word lines (61-64) running in the transverse direction along the main area of the semiconductor substrate (10) and serving for driving the first and second selection transistors (T1, T2) in the respective gate regions;
insulated bit lines (91-94) running in an oblique direction along the main area of the semiconductor substrate (10) and serving for connecting the first and second selection transistors (T1, T2) in the respective source regions (80); and
a respective, preferably ferroelectric, capacitor connected to the drain region of the relevant selection transistor (T1, T2) via a capacitor contact (70).

2. Memory cell arrangement according to Claim 1, **characterized in that** insulating spacers (40a-h) preferably made of nitride or oxide, are provided along the trench walls.

3. Memory cell arrangement according to Claim 2, **characterized in that** the trenches (1a-c) are wider than the ridges (2a-d) by the thickness of the spacers (40a-h).

4. Memory cell arrangement according to one of the preceding claims, **characterized in that** insulating spacers, preferably made of nitride or oxide, are provided along the word lines (61-64) and/or bit lines (91-94).

5. Memory cell arrangement according to one of the preceding claims, **characterized in that** the trenches (1a-c) are filled with an insulator layer through which run respective first contact plugs for connecting the first selection transistors (T1) to the bit lines (91-94).

6. Memory cell arrangement according to one of the preceding claims, **characterized in that** the ridges (2a-d) are covered with an insulator layer through which run respective second contact plugs for connecting the second selection transistors (T2) to the bit lines (91-94).

7. Memory cell arrangement according to one of the preceding claims, **characterized in that** a further insulator layer is provided on the word lines (61-64) and bit lines (91-94), and respective stacked capacitors are provided which are connected to the drain region of the relevant selection transistor (T1, T2) via the respective capacitor contact (70).

8. Memory cell arrangement according to Claim 7, **characterized in that** a layer made of a ferroelectric, preferably made of strontium bismuth tantalate, or a dielectric, preferably oxide, silicon nitride, tantalum pentoxide layer (Ta₂O₅) or titanium dioxide layer (TiO₂) or barium strontium titanate, is provided in the stacked capacitors.

9. Memory cell arrangement according to Claim 7 or 8, **characterized in that** a common top capacitor electrode is provided in a large-area manner above the layer made of a ferroelectric.

10. Memory cell arrangement according to one of the preceding claims, **characterized in that** the trenches (1a-c), the ridges (2a-d), the word lines (61-64) and the bit lines (91-94) each have a minimum structural width F, and each memory cell occupies an area of 4 F².

11. Method for fabricating a memory cell arrangement having preferably ferroelectric memory cells according to at least one of the preceding claims, having the steps of:
providing the semiconductor substrate (10);
providing a channel stop layer (20), which divides the semiconductor substrate (10) into a lower region (10a) including the trench bottoms and an upper region (10b) including the ridge crowns;
providing a periodic arrangement of alternate trenches (1a-c) and ridges (2a-d) running parallel in the longitudinal direction in the main area of the semiconductor substrate (10);
forming trench channel stop regions (22) in the trenches (1a-c) and ridge channel stop regions (24) on the ridges (2a-d), which define first and second selection transistors (T1, T2) which have respective source, gate, channel and drain regions which are offset with respect to one another in the longitudinal direction in such a way that source and drain regions (582, 551) of the first and second selection transistors (T1, T2) alternate in the transverse direction in the main area of the semiconductor substrate (10);
forming the source, gate, channel and drain regions of the first and second selection transistors (T1, T2);
forming insulated word lines (61-64) running in the transverse direction along the main area of the semiconductor substrate (10) and serving for driving the first and second selection transistors (T1, T2) in the respective gate regions;
forming insulated bit lines (91-94) running in an oblique direction along the main area of the semiconductor substrate (10) and serving for connecting the first and second selection transistors (T1, T2) in the respective source regions (80); and
forming a respective, preferably ferroelectric, capacitor connected to the drain region of the relevant selection transistor (T1, T2) via a capacitor contact (70).

12. Method according to Claim 11, **characterized by** the steps of:
carrying out self-aligning source/drain implantations for simultaneously forming the source and drain regions (e.g. 551, 552 and 581, 582, respectively) of the first and second selection transistors.

13. Method according to Claim 11 or 12, **characterized in that** the process of forming the ridge channel stop regions (24) on the ridges (2a-d) takes place by means of the following steps:
deposition and planarization of TEOS oxide for filling the trenches (1a-c);
selective formation of the ridge channel stop regions (24) in the ridges; and
removal of the TEOS oxide.

14. Method according to one of Claims 11 to 13, **characterized in that** insulating spacers (40a-h) are formed along the trench walls.

## Revendications

1. Dispositif à cellules de mémoire comportant une multiplicité de cellules de mémoire ferroélectriques ou dynamiques (S), prévues dans un substrat semiconducteur (10), comportant:
des sillons (1a-1e) et des barrettes (2a-d), qui alternent et s'étendent parallèlement dans la direction longitudinale, dans la surface principale du substrat semiconducteur (10);
dans lequel
dans les barrettes (2a-d) est ensevelie une couche d'arrêt de canal (20), qui divise le substrat semiconducteur (10) en une partie inférieure (10a) incluant les fonds des sillons et en une partie supérieure (10b) incluant les sommets des barrettes;
des premiers transistors planars de sélection (T1), entre lesquels sont intercalées des zones d'arrêt de canal (22) dans les sillons, sont disposés le long des fonds des sillons dans la partie inférieure (10a) du substrat semiconducteur (10);
des seconds transistors à structure plane de sélection (T2), entre lesquels sont intercalées des zones d'arrêt de canal (24) dans les barrettes, sont disposés le long des sommets des barrettes dans la partie supérieure (10b) du substrat semiconducteur (10);
les premiers et seconds transistors de sélection (T1, T2) possèdent des régions respectives de grille, de canal et de drain, qui sont décalées les unes par rapport aux autres dans la direction longitudinale de telle sorte que des régions de source et de drain (582, 551) des premiers et seconds transistors de sélection (T1, T2) alternent dans la direction transversale, dans la surface principale du substrat semiconducteur (10);
comportant des conducteurs de mots isolés (61-64), qui s'étendent dans la direction transversale le long de la surface principale du substrat semiconducteur (10) et servent à commander les premiers et seconds transistors de sélection (T1, T2) dans les zones de grille respectives;
des conducteurs de bits isolés (91-94), qui s'étendent dans une direction oblique le long de la surface principale du substrat semiconducteur (10) et servent à raccorder les premiers et seconds transistors de sélection (T1, T2) dans les zones respectives de source (80); et
respectivement un condensateur de préférence ferroélectrique, qui est relié par l'intermédiaire d'un contact de condensateur (70) à la région de drain du transistor de sélection considéré (T1, T2).

2. Dispositif à cellules de mémoire selon la revendication 1, **caractérisé en ce qu'**il est prévu, le long des parois des sillons, des entretoises isolantes (40a-h), formées de préférence d'un nitrure ou d'un oxyde.

3. Dispositif à cellules de mémoire selon la revendication 2, **caractérisé en ce que** les sillons (1a-c) sont plus larges que les barrettes (2a-d), et ce de l'épaisseur des entretoises (40a-h).

4. Dispositif à cellules de mémoire selon l'une des revendications précédentes, **caractérisé en ce que** des entretoises isolantes, formées de préférence d'un nitrure ou d'un oxyde sont prévues le long des conducteurs de mots (61-64) et/ou des conducteurs de bits (91-94).

5. Dispositif à cellules de mémoire selon l'une des revendications précédentes, **caractérisé en ce que** les sillons (1a-c) sont remplis par une couche isolante, dans laquelle s'étendent les premières fiches de contact individuelles servant à relier les premiers transistors de sélection (T1) aux conducteurs de bits (91-94).

6. Dispositif à cellules de mémoire selon l'une des revendications précédentes, **caractérisé en ce que** les barrettes (2a-d) sont recouvertes par une couche isolante, dans laquelle s'étendent des secondes fiches respectives de contact destinées à relier les seconds transistors de sélection (T2) aux lignes de bits (91-94).

7. Dispositif à cellules de mémoire selon l'une des revendications précédentes, **caractérisé en ce qu'**une autre couche isolante est prévue sur les conducteurs de mots (61-64) et sur les conducteurs de bits (91-94) et qu'il est prévu des condensateurs respectifs à empilage qui sont reliés par l'intermédiaire du contact respectif de condensateur (70) à la région de drain du transistor de sélection considéré (T1, T2).

8. Dispositif à cellules de mémoire selon la revendication 7, **caractérisé en ce qu'**il est prévu, dans les condensateurs à empilage une couche formée d'un matériau ferroélectrique, de préférence du tantalate de strontium et de bismuth ou un diélectrique de préférence un oxyde, du nitrure de silicium, une couche de pentoxyde de tantale (Ta₂O₅) ou une couche de dioxyde de titane (TiO₂) ou du titanate de baryum-strontium .

9. Dispositif à cellules de mémoire selon la revendication 7 ou 8, **caractérisé en ce qu'**une électrode commune supérieure de condensateur est prévue sur une surface étendue au-dessus de la couche formée d'un matériau diélectrique.

10. Dispositif à cellules de mémoire selon l'une des revendications précédentes, **caractérisé en ce que** les sillons (1a-c), les barrettes (2a-d), les conducteurs de mots (61-64) et les conducteurs de bits (91-94) possèdent respectivement une largeur de structure minimale F, et que chaque cellule de mémoire occupe une surface égale à 4F².

11. Procédé pour fabriquer un dispositif à cellules de mémoire de préférence ferroélectriques selon au moins l'une des revendications précédentes, comprenant les étapes consistant à:
préparer le substrat semiconducteur (10);
prévoir une couche d'arrêt de canal (20), qui divise le substrat semiconducteur (10) en une partie inférieure (10a) incluant les fonds des sillons et une partie supérieure (10b) incluant les sommets des barrettes;
prévoir une disposition périodique de sillons (1a-c) et de barrettes (2a-c) qui alternent et s'étendent parallèlement dans la direction longitudinale dans la surface principale du substrat semiconducteur (10) ;
former des régions d'arrêt de canal de sillons (22) dans les sillons (1a-c) et des régions d'arrêt de canal de barrettes (24) sur les barrettes (2a-d), ces régions d'arrêt de canal définissant des premiers et seconds transistors de sélection (T1, T2), qui possèdent des régions respectives de source, de grille, de canal et de drain, qui sont décalées réciproquement dans la direction longitudinale de telle sorte que des régions de source et
de drain (582, 551) des premiers et seconds transistors de sélection (T1, T2) alternent dans la direction transversale, dans la surface principale du substrat semiconducteur (10);
former les régions de source, de grille, de canal et de drain des premiers et seconds transistors de sélection (T1, T2);
former des conducteurs de mots isolés (61-64), qui s'étendent dans la direction transversale le long de la surface principale du substrat semiconducteur (10) pour commander les premiers et seconds transistors de sélection (T1, T2) dans les régions respectives de grille;
former des conducteurs de mots isolés (91- 94) qui s'étendent dans une direction oblique le long de la surface principale du substrat semiconducteur (10) et servent au raccordement des premiers et seconds transistors de sélection (T1, T2) dans les régions respectives de source (80); et
former respectivement un condensateur de préférence ferroélectrique, qui est relié par l'intermédiaire d'un contact de condensateur (70) à la région de drain du transistor de sélection considéré (T1, T2).

12. Procédé selon la revendication 11, **caractérisé par** les étapes consistant à:
effectuer des implantations à auto-alignement de sources/drains pour la formation simultanée des régions de source et de drain (par exemple 551, 552 ou 581, 582) des premiers et seconds transistors de sélection.

13. Procédé selon la revendication 11 ou 12, **caractérisé en ce que** la formation des régions d'arrêt de canal de barrettes (24) sur les barrettes (2a-d) est exécutée au moyen des étapes suivantes consistant à:
déposer et planariser un oxyde TEOS pour remplir les sillons (1a-c);
former sélectivement les régions d'arrêt de canal de barrettes (24) dans les barrettes; et
éliminer l'oxyde TEOS.

14. Procédé selon l'une des revendications 11 à 13, **caractérisé en ce qu'**on forme des entretoises isolantes (40a-h) le long des parois des sillons.
